**Europäisches Patentamt**

**European Patent Office**

**Office européen des brevets**

(19)

(11) Veröffentlichungsnummer : **0 370 239 B1**

(12)

# EUROPÄISCHE PATENTSCHRIFT

(45) Veröffentlichungstag der Patentschrift :
**25.11.92 Patentblatt 92/48**

(51) Int. Cl.$^5$ : **C25D 5/06**, C25D 5/00

(21) Anmeldenummer : **89119596.8**

(22) Anmeldetag : **23.10.89**

(54) **Vorrichtung zur selektiven galvanischen Beschichtung.**

(30) Priorität : **19.11.88 DE 3839223**

(43) Veröffentlichungstag der Anmeldung :
**30.05.90 Patentblatt 90/22**

(45) Bekanntmachung des Hinweises auf die
Patenterteilung :
**25.11.92 Patentblatt 92/48**

(84) Benannte Vertragsstaaten :
**BE DE FR GB IT NL**

(56) Entgegenhaltungen :
**EP-A- 0 222 232**

(56) Entgegenhaltungen :
**PATENT ABSTRACTS OF JAPAN, Band 11, Nr. 365 (C-460)[2812], 27. November 1987; & JP-A-62 136 587 (ELECTROPLATING ENGINEER-SOF JAPAN) 19-06-1987**

(73) Patentinhaber : **Degussa Aktiengesellschaft
Weissfrauenstrasse 9
W-6000 Frankfurt am Main 1 (DE)**

(72) Erfinder : **Wingenfeld, Peter, Dipl.-Ing.
Degenfelderstrasse 26/2
W-7070 Weiler i.d.B. (DE)**
Erfinder : **Holdt, Dietmar, Dipl.-Ing.
Staufenstrasse 19
W-7078 Leinzell (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Vorrichtung zur selektiven galvanischen Beschichtung von kontinuierlich oder diskontinuierlich an einer stabförmigen, im Querschnitt mit einer oder mehreren Kanten versehenen Anode vorbeigeführten elektrisch leitenden Gegenständen durch Inberührungbringen mit einem auf einem Elektrolytträger verteilten Elektrolyten, wobei der Elektrolytträger mit einem Band aus einem flüssigkeitsdurchlässigen, saugfähigen und abriebfestem Material in Verbindung steht, das die Anode teilweise oder auf ihrer ganzen Länge umschließt.

Kontaktstifte, Kontaktfedern oder Kontaktbänder müssen vorzugsweise partiell galvanisch beschichtet, insbesondere mit Edelmetallen versehen werden, um elektrische Eigenschaften, Härte oder Abriebbeständigkeit an diesen für die Kontaktierung wichtigen Stellen zu verbessern.

Dies geschieht in der Regel in Vorrichtungen mit stationären oder mitlaufenden Abdeckmasken, wie beispielsweise in US-A-41 32 617, US-A-44 25 212, WO-OS 87/02 076 und DE-OS 29 28 904 beschrieben. Hierbei sind die Herstellung, bzw. der apparative Aufwand der Markiertechnik sehr hoch und teuer, Elektrolytverluste durch Ausschleppung nur schwer vermeidbar und die Einhaltung der geforderten Toleranzen, bedingt durch Temperaturwechsel, Verformung oder Längenänderungen, nicht oder nur ungenügend gewährleistet.

Aus der US-A-4610 772 und EP-A-0154 795 sind Vorrichtungen zur selektiven Beschichtung bekannt, bei der die Anoden aus Rollen bestehen, die mit Belägen aus saugfähigen Geweben versehen sind und bei denen die Rolle in den Elektrolyt eingetaucht oder über die der Elektrolyt zugeführt wird.

Durch Inkontaktbringen der metallischen Gegenstände mit dem mit Elektrolyt getränkten Gewebe erfolgt die Metallabscheidung auf den Gegenständen. Nachteilig sind hierbei unzureichende Begrenzung und unzureichende Gleichmäßigkeit der Schichten. In den meisten Fällen muß zusätzlich abgedeckt oder abgeklebt werden, um nichtzubeschichtende Flächen zu schützen,

Die US-A-4452 684 beschreibt eine Vorrichtung mit einer feststehenden porösen Anode, an der die Gegenstände vorbeigeführt werden und bei der der Elektrolyt über eine hohle Achse zugeführt wird. Durch die allseitige Beaufschlagung mit Elektrolyt ergeben sich gleichfalls ungleichmäßige Abscheidungen und Schichtdicken.

Aus der DE-PS 37 30 740 ist eine Vorrichtung zur selektiven galvanischen Beschichtung von kontinuierlich an einer Anode vorbeigeführten Gegenständen bekannt. Die Anode steht in Kontakt mit einem Elektrolytträger. Die Beschichtung erfolgt durch Inberührungbringen der Gegenstände mit einem Elektrolytträger, auf dem der Elektrolyt verteilt ist. Der Elektrolyt wird über eine ebene Fläche des Kanten aufweisenden Elektrolytträgers aufgetragen, der mit der Anode in Verbindung steht und in mechanische Schwingungen versetzt wird. Die Beschichtungen sind hierbei in speziellen Fällen nicht genügend konturenscharf.

Aus der EP-A-0 222 232 ist eine Vorrichtung zur selektiven galvanischen Beschichtung von Gegenständen bekannt, durch Inberührung bringen mit einer mit Kanten versehenen Anode, die mit einem Band aus einem flüssigkeitsdurchlässigen Material umgeben ist, auf dem sich der Elektrolyt verteilt. Die Elektrolytzuführung erfolgt über einzelne Kanäle, was zu einer ungleichmäßigen Verteilung des Elektrolyten auf dem Band führt. Konturenscharfe und sehr gleichmäßige Schichten sind mit dieser Anodenkonstruktion nicht herstellbar.

Es war daher Aufgabe der vorliegenden Erfindung, eine Vorrichtung zur selektiven galvanischen Beschichtung elektrisch leitender Gegenstände gemäß dem Oberbegriff von Patentanspruch 1 zu entwickeln, das eine gleichmäßige Schichtverteilung und eine scharfe Schichtenbegrenzung ohne Abdeckmedien gewährleistet. Es sollte außerdem sichergestellt werden, daß unterschiedlich geformte Gegenstände mit hoher Abscheidegeschwindigkeit bei kleinem Elektrolytvolumen kontinuierlich oder diskontinuierlich beschichtet werden können.

Diese Aufgabe wird erfindungsgemäß durch die Maßnahme des kennzeichnenden Teils von Patentanspruch 1 gelöst. Vorteilhafte Ausgestaltungen der Vorrichtung ergeben sich aus den Unteransprüchen. Die stabförmige, mit einer oder mehreren Kanten versehene Anode enthält in unmittelbarer Nähe der Anodenkanten in Längsrichtung ein oder zwei, parallel zu den Kanten ausgerichtete Elektrolytträger, die bündig mit der Anodenoberfläche abschließen und als Streifen in den Anodenkörper ringelassen sind.

Der oder die Elektrolytträger stehen mit einem Band aus einem flüssigkeitsdurchlässigen, saugfähigen und abriebbeständigen Material in Verbindung, welches die Anodenkante teilweise oder auf ihrer gesamten Länge eng umschließt und elektrische Kurzschlüsse vermeidet.

Es hat sich als günstig erwiesen, wenn das Band mittels Klettverschluß geöffnet und geschlossen werden kann und wenn durch eine Spannvorrichtung eine gleichmäßige Spannung des Bandes erfolgt und somit Falten oder Aufbauchungen vermieden werden können. Als Material für das Band und den Elektrolytträger werden Filze, Gewebe oder Gestricke aus natürlichen oder künstlichen Fasern verwendet.

Die Querschnittsgeometrie des Anodenkörpers kann segmentförmig, kreisausschnittförmig halbrund sein, vorteilhaft ist jedoch ein dreieckiger Querschnitt. Als Material haben sich alle korrosionsbeständigen Werkstoffe bewährt.

Für die Elektrolytzuführung eignen sich besonders Elektrolytzuführungskanäle im oder am Anodenkörper, die mit einem saugfähigen, flüssigkeitsdurchlässigen Material ausgefüllt sind. Dieses Material eignet sich hervorragend als Elektrolytsammelkörper und zusätzliches Filter. Die Elektrolytzuführungskanäle stehen mit dem Elektrolytträger längs des gesamten Anodenkörpers über Verbindungskanäle zueinander in Verbindung und werden mit Elektrolyt versorgt. Die Zuführung des Elektrolyts aus einem Vorratsbehälter zu den Elektrolytzuführungskanälen erfolgt vorzugsweise über einen Anschluß an beiden Stirnflächen. Ein zusätzlicher Vorteil besteht darin, daß die Elektrolytzuführungskanäle mit einer Heizeinrichtung versehen werden können.

Das Heizmedium kann Wasser sein, vorteilhaft ist jedoch eine Bypass-Leitung aus dem Elektrolytvorratsbehälter ohne zusätzlichen Energieverbrauch. Der Vorteil der Elektrolytaufheizung besteht darin, daß an der Anodenkante überall eine gleichmäßige Temperatur vorliegt und der großflächige Anodenkörper nicht als Kühlkörper wirken kann.

Von Vorteil ist es auch, die Elektrolytträgerstreifen in einem sehr engen Abstand zur nächsten Anodenkante anzubringen, um zusätzliche positive Fließeigenschaften des Elektrolyten zu erreichen.

Für die Durchflußregelung des Elektrolyten ist es weiterhin von Vorteil, die Verbindungskanäle mit austauschbaren Düsen zu versehen, die dann für eine gleichmäßige Flüssigkeitsbenetzung bzw. ein vorgegebenes Elektrolytvolumen im Bereich der Anodenkante des Elektrolytträgers sorgen. Dadurch ergibt sich neben den technischen Vorteilen einer sehr genauen Selektivität auch ein wirtschaftlicher Vorteil, daß mit relativ wenig Edelmetallelektrolytvolumen gearbeitet werden kann. In der Regel werden Elektrolytvolumen von ca 120 - 125 Liter benötigt, bei der Anwendung der erfindungsgemäßen Vorrichtung werden Volumeneinsparungen von bis zu 80 % erzielt.

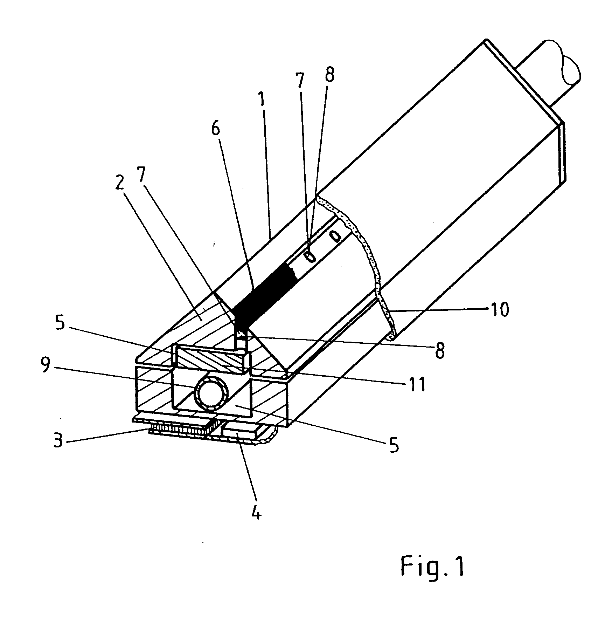

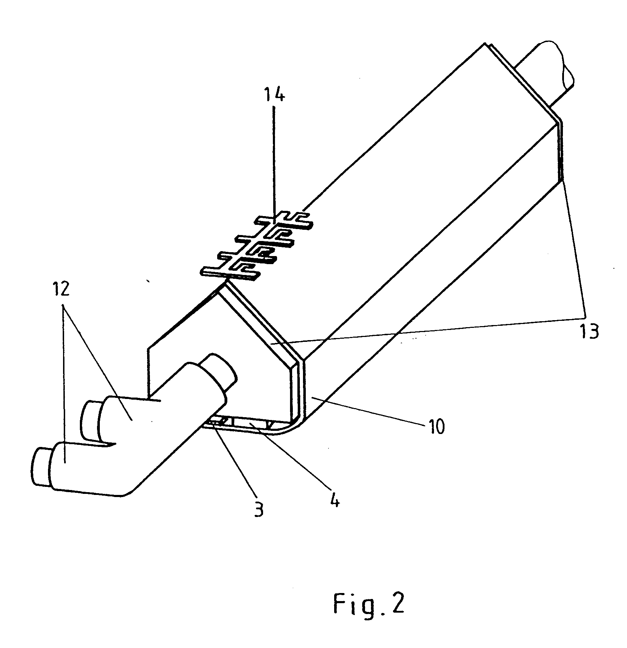

Die erfindungsgemäße Vorrichtung wird schematisch in beispielhafter Ausführungsform anhand der Figuren 1 und 2 näher erläutert.

Figur 1 zeigt eine Ausgestaltung des Anodenkörpers und Figur 2 die Zuführungsleitungen mit den stirnseitigen Anschlußplatten.

Die Vorrichtung besteht im wesentlichen aus einem stabförmigen Anodenkörper (2), der ein oder mehrere Anodenkanten (1) besitzt. An diesen Kanten (1) werden die zu beschichtenden Gegenstände (14) entlanggeführt.

Zwischen der Anodenkante (1) und dem zu beschichtenden Gegenstand (14) befindet sich ein flüssigkeitsdurchlässiges Band (10). Dieses Band (10) steht in Verbindung mit dem Elektrolytträger (6), der in den Anodenkörper (2) eingelegt ist.

Zum Verschließen und Öffnen des Bandes (10) sowie zur falten- und verzugsfreien Spannung dient ein Klettverschluß (3) und eine Spannvorrichtung (4). Der Elektrolyt wird über die Zuführungsanschlüsse (12) in den Anodenkörper (2) eingebracht. Die Anschlüsse (12) befinden sich an beiden stirnseitigen Anschlußplatten (13). Durch den Elektrolytzuführungskanal (5) gelangt der Elektrolyt über ein saugfähiges Material (11) in die Verbindungskanäle (7).

Mit Hilfe austauschbarer Düsen (8) wird der Elektrolyt dem Elektrolytträger (6) zugeführt und tritt über das Band (10) an der Anodenkante (1) nach außen. Diese mit Elektrolyt gleichmäßig befeuchtete Anodenkante (1) wird mit den zu beschichtenden Oberflächenbereichen der elektrisch leitenden Gegenstände (14) in Berührung gebracht. Durch diesen gezielt an der Anodenkante (1) dosierten Elektrolyten wird ein hohes Maß an Selektivität gewährleistet. Um für eine gleichmäßige Temperatur des Elektrolyten zu sorgen, wird in die Elektrolytzuführungskanäle (5) eine Heizvorrichtung (9) eingebracht. Die Heizung kann mittels elektrischen Heizstäbchen oder mit flüssigkeitsgefüllten Heizrohren betrieben werden.

Durch diese Vorrichtung wird ein fast theoretischer Metallverbrauch realisiert. Im Vergleich zu derzeit üblichen Selektivtechniken werden dadurch Metall-Einsparungen bis zu 80 % erzielt. Ein weiterer Vorteil ist darin zu sehen, daß z.B. bei Goldbeschichtungen an den Schnittkanten und der Rückseite nur ein vernachlässigbarer Goldflash abgeschieden wird und daß dadurch das Zurückstrippen dieser unnötigen Beschichtung entfällt.

**Patentansprüche**

1. Vorrichtung zur selektiven galvanischen Beschichtung von kontinuierlich oder diskontinuierlich an einer stabförmigen, im Querschnitt mit einer oder mehreren Kanten versehenen Anode vorbeigeführten elektrisch leitenden Gegenständen durch Inberührungbringen mit einem auf einem Elektrolytträger verteilten Elektrolyten, wobei der Elektrolytträger mit einem Band aus einem flüssigkeitsdurchlässigen, saugfähigen und abriebfesten Material in Verbindung steht, das die Anode teilweise oder auf ihrer gesamten Länge eng umschließt,
dadurch gekennzeichnet,
daß in unmittelbarer Nähe zu einer oder mehreren Anodenkanten (1) in Längsrichtung parallel zu den Kanten jeweils ein oder zwei Elektrolytträger (6) als mit der Anodenoberfläche bündig abschließende Streifen in den Anodenkörper (2) eingelassen sind, die aus Filzen, Geweben oder Gestricken von natürlichen oder künstlichen Fasern bestehen.

2. Vorrichtung nach Anspruch 1,
dadurch gekennzeichnet,
daß der Anodenkörper (2) einen dreieckigen Querschnitt aufweist.

3. Vorrichtung nach Anspruch 1 oder 2,
dadurch gekennzeichnet,
daß im oder am Anodenkörper (2) sich Elektrolytzuführungskanäle (5) befinden, die mit einem saugfähigen, flüssigkeitsdurchlässigen Material (11) ausgefüllt sind und diese Elektrolytzuführungskanäle (5) längs des gesamten Anodenkörpers (2) mit dem Elektrolytträger (6) über Verbindungskanäle (7) in Verbindung stehen.

4. Vorrichtung nach Anspruch 1 bis 3,
dadurch gekennzeichnet,
daß die Elektrolytzuführungskanäle (5) an beiden Stirnflächen des Anodenkörpers (2) mit Anschlüssen (12) für die Elektrolytzufuhr versehen sind.

5. Vorrichtung nach Anspruch 1 bis 4,
dadurch gekennzeichnet,
daß die Elektrolytzuführungskanäle (5) mit einer Heizvorrichtung (9) versehen sind.

6. Vorrichtung nach Anspruch 1 bis 5,
dadurch gekennzeichnet,
daß die Elektrolytträgerstreifen (6) in einem Abstand von 1 bis 20 mm von der Anodenkante (1) angeordnet sind, gemessen vom kantennächsten Rand des Streifens.

7. Vorrichtung nach Anspruch 1 bis 6,
dadurch gekennzeichnet,
daß die Verbindungskanäle (7) mit austauschbaren Düsen (8) versehen sind.

## Claims

1. Device for the selective electroplating of electrically conductive objects which are moved continuously or intermittently past an anode in the form of a rod having one or more edges in cross-section by bringing said objects into contact with an electrolyte distributed over an electrolyte carrier, said electrolyte carrier communicating with a band of a liquid permeable, absorbent and abrasion resistant material closely covering the anode partially or over its whole length, characterised in that one or two electrolyte carriers (6) in the form of strips ending flush with the anode surface and consisting of felts, non-woven webs or knitted webs of natural or synthetic fibres are inserted in the anode body (2) in the immediate vicinity of one or more anode edges (1) in the longitudinal direction parallel to the edges.

2. Device according to Claim 1, characterised in that the anode body (2) is triangular in cross-section.

3. Device according to Claim 1 or 2, characterised in that the anode body (2) contains electrolyte supply channels (5) which are filled with an absorbent, liquid permeable material (11) and these electrolyte supply channels (5) communicate with the electrolyte carrier (6) via connecting channels (7) over the whole length of the anode body (2).

4. Apparatus according to Claims 1 to 3, characterised in that the electrolyte supply channels (5) are provided with connections (12) for the supply of electrolyte at both end faces of the anode body (2).

5. Device according to Claims 1 to 4, characterised in that the electrolyte supply channels (5) are equipped with a heating device (9).

6. Device according to Claims 1 to 5, characterised in that the electrolyte carrier strips (6) are arranged at a distance of from 1 to 20 mm from the anode edge (1), measured from the edge of the strip closest to the edge of the anode.

7. Device according to Claims 1 to 6, characterised in that the connecting channels (7) have replaceable nozzles (8).

## Revendications

1. Dispositif pour un revêtement galvano-plastique sélectif d'objets conducteurs électriques amenés de façon continue ou discontinue contre une anode en forme de barre, munie en section transversale d'une ou plusieurs arêtes, et par mise au contact d'un électrolyte réparti sur un support d'électrolyte, le support d'électrolyte étant en liaison avec un ruban d'une matière perméable aux liquides, absorbante et résistante à l'abrasion, qui entoure l'anode étroitement partiellement ou sur toute sa longueur, caractérisé en ce qu'un ou deux supports d'électrolyte (6) sont encastrés dans le corps d'anode (2) comme des bandes séparées, à fleur de la surface de l'anode, disposés respectivement à proximité immédiate d'une ou plusieurs arêtes d'anode (1) dans le sens longitudinal et parallèlement aux arêtes, ces supports d'électrolyte sont constitués de feutres, de tissus ou de tricots de fibres naturelles ou artificielles.

2. Dispositif selon la revendication 1, caractérisé en ce que le corps d'anode (2) a une section triangulaire.

3. Dispositif selon la revendication 1 ou la revendication 2, caractérisé en ce que des canaux d'alimentation d'électrolyte (5) se trouvent dans ou contre le corps d'anode (2), ils sont comblés d'une matière (11) absorbante, perméable aux liquides et ils sont en liaison le long de tout le corps d'anode (2) avec le support d'électrolyte (6) par l'intermédiaire de conduits de liaison (7).

4. Dispositif selon les revendications 1 à 3, caractérisé en ce que les canaux d'alimentation en électrolyte (5) sont équipés sur les deux faces frontales du corps d'anode (2) de raccords (12) pour l'alimentation de l'électrolyte.

5. Dispositif selon les revendications 1 à 4, caractérisé en ce que les canaux d'alimentation en électrolyte (5) sont munis d'un dispositif de chauffage (9).

6. Dispositif selon les revendications 1 à 5, caractérisé en ce que les bandes de support d'électrolyte (6) sont placées à une distance de 1 à 20 mm de l'arête d'anode (1), mesurée à partir du bord de la bande la plus proche de l'arête.

7. Dispositif selon les revendications 1 à 6, caractérisé en ce que les conduits de liaison (7) sont munis d'ajutages (8) échangeables.

Fig. 1

14

12

13

10

4

3

Fig.2